# FASCICULE DE BREVET EUROPEEN

(11) **EP 4 235 765 B1**
(45) Date de publication et mention de la délivrance du brevet: **04.02.2026**
(21) Numéro de dépôt: 23175870.7
(22) Date de dépôt: 11.12.2019
(51) Int. Cl.: H10D 86/01, H10D 86/00

(54) **PROCÉDÉ AMÉLIORÉ DE FABRICATION D'UN CIRCUIT INTÉGRÉ COMPORTANT UN TRANSISTOR NMOS ET UN TRANSISTOR PMOS**
VERBESSERTES HERSTELLUNGSVERFAHREN EINES INTEGRIERTEN SCHALTKREISES, DER EINEN NMOS- UND EINEN PMOS-TRANSISTOR UMFASST
IMPROVED METHOD FOR MANUFACTURING AN INTEGRATED CIRCUIT COMPRISING AN NMOS TRANSISTOR AND A PMOS TRANSISTOR

(30) Priorité: 18.12.2018 FR 1873216
(43) Date de publication de la demande: 30.08.2023
(62) Demande divisionnaire de: 19215347.6
(73) Titulaire: Commissariat à l'Energie Atomique et aux Energies Alternatives, 75015 Paris (FR)
(72) Inventeur: POSSEME, Nicolas, 38054 Grenoble Cedex 09 (FR); GABEN, Loïc, 38054 Grenoble Cedex 09 (FR); LE ROYER, Cyrille, 38054 Grenoble Cedex 09 (FR); NEMOUCHI, Fabrice, 38054 Grenoble Cedex 09 (FR); REBOH, Shay, 38054 Grenoble Cedex 09 (FR)
(74) Mandataire: INNOV-GROUP

(56) Documents cités:
- EP-A1- 1 968 103
- EP-A1- 2 782 118
- US-A1- 2012 068 267
- US-A1- 2015 099 335
- US-A1- 2017 309 483

## Description

L'invention concerne la fabrication de transistors de type Silicium sur isolant, et en particulier la fabrication de transistors de type Silicium sur isolant présentant des propriétés de mobilité améliorées des charges dans leurs canaux.

Afin d'augmenter la mobilité dans le canal des transistors pMOS et de limiter le décalage de tension de seuil par rapport à un transistor nMOS cointégré, il est connu de déposer une couche de SiGe par épitaxie sur une couche de Silicium, puis de réaliser une oxydation thermique et un recuit, de façon à réaliser une condensation concentrant le Germanium dans la couche de Silicium.

Par ailleurs, en vue d'améliorer la mobilité dans le canal des transistors nMOS, il est connu de réaliser un procédé dit STRASS. Ce procédé inclut un dépôt de SiGe sur une couche de Silicium, une relaxation du SiGe et une amorphisation de sa partie inférieure et de la couche de silicium. Ensuite, on procède à la recristallisation de la couche de SiGe depuis son sommet et à la recristallisation de la couche de Silicium pour la contraindre en tension. Après retrait de la couche de SiGe, la couche de Silicium reste contrainte en tension.

La mise en œuvre de ces procédés de fabrication permet théoriquement d'obtenir la combinaison de transistors nMOS et de transistors pMOS avec des propriétés appropriées. En revanche, la mise en œuvre de tels procédés de fabrication nécessite un très grand nombre d'étapes de processus industriels et la mise en œuvre d'un grand nombre d'étapes de photolithographie. Un tel procédé de fabrication présente ainsi un coût actuellement trop élevé pour permettre une telle combinaison de transistors.

L'invention vise à résoudre un ou plusieurs de ces inconvénients. L'invention porte ainsi sur un procédé de fabrication d'un circuit intégré, tel que défini dans les revendications annexées.

L'invention porte également sur les variantes des revendications dépendantes. L'homme du métier comprendra que chacune des caractéristiques de la description ou des revendications dépendantes peut être combinée indépendamment aux caractéristiques d'une revendication indépendante, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :
[Fig. 1] et
[Fig. 2] sont respectivement des vues en coupe et de dessus d'un substrat FDSOI (désignant un Silicium sur isolant totalement déserté) destiné à former un transistor nMOS et un transistor pMOS ;
[Fig. 3],
[Fig. 4],
[Fig. 5],
[Fig. 6],
[Fig. 7],
[Fig. 8],
[Fig. 9],
[Fig. 10],
[Fig. 11],
[Fig. 12],

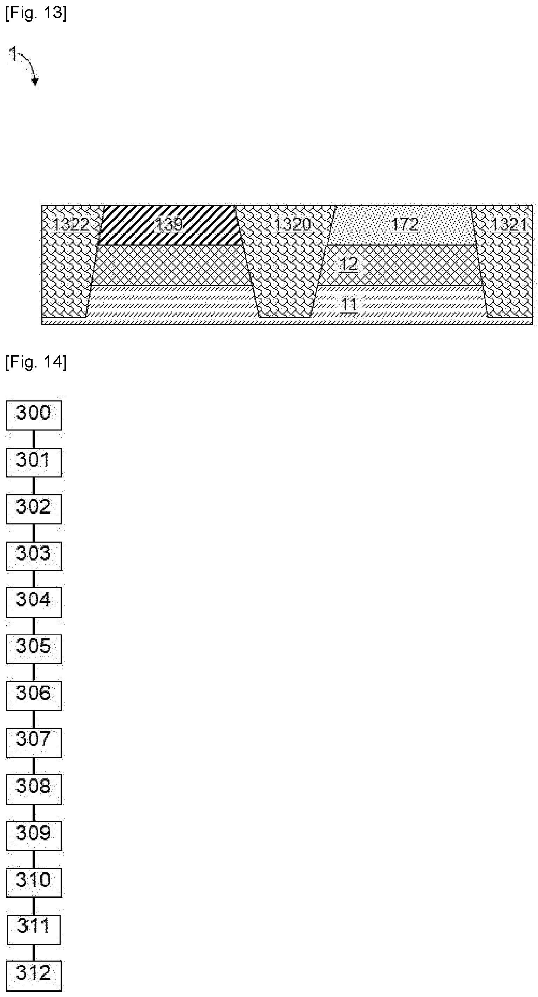

[Fig. 13] sont des vues en coupe desdits transistors nMOS et pMOS à différentes étapes de leur procédé de fabrication selon un premier mode de réalisation qui n'est pas couvert par le texte des revendications
[Fig.14] est un diagramme illustrant les étapes du procédé de fabrication selon le premier mode de réalisation ;
[Fig. 15],
[Fig. 16],
[Fig. 17],
[Fig. 18],
[Fig. 19],
[Fig. 20],
[Fig. 21],
[Fig. 22],
[Fig. 23],
[Fig. 24],
[Fig. 25],
[Fig. 26],

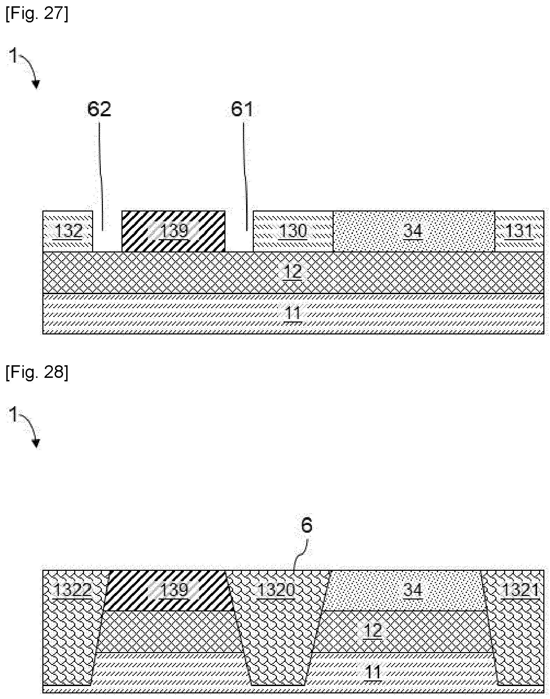

[Fig. 27] et
[Fig. 28] sont des vues en coupe desdits transistors nMOS et pMOS à différentes étapes de leur procédé de fabrication selon un deuxième mode de réalisation, couvert par le texte des revendications;
[Fig. 29],
[Fig. 30],
[Fig. 31],
[Fig. 32],
[Fig. 33],
[Fig. 34],
[Fig. 35],
[Fig. 36],
[Fig. 37],
[Fig. 38],
[Fig. 39],

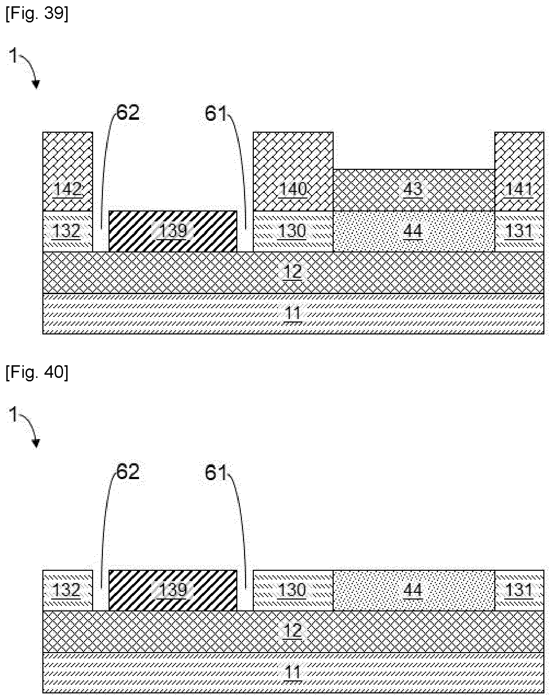

[Fig. 40] et

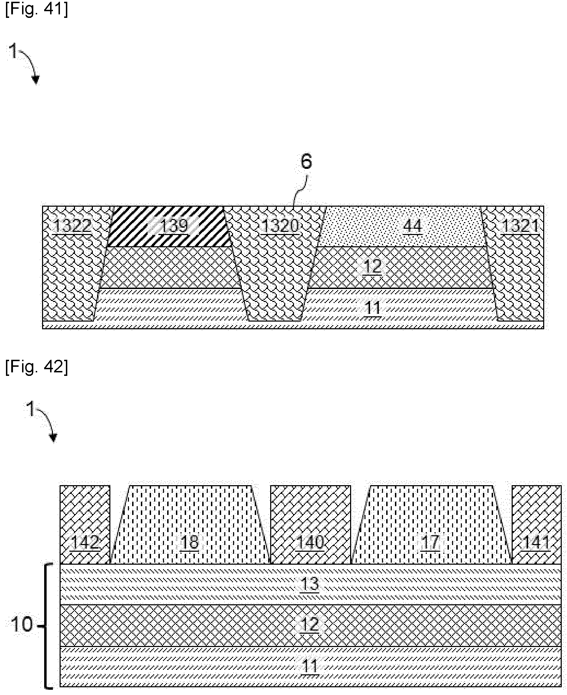

[Fig. 41] sont des vues en coupe desdits transistors nMOS et pMOS à différentes étapes de leur procédé de fabrication selon un troisième mode de réalisation, qui n'est pas couvert par le texte des revendications;
[Fig. 42],
[Fig. 43],
[Fig. 44],
[Fig. 45],
[Fig. 46],
[Fig. 47],
[Fig. 48],
[Fig. 49],
[Fig. 50],
[Fig. 51],

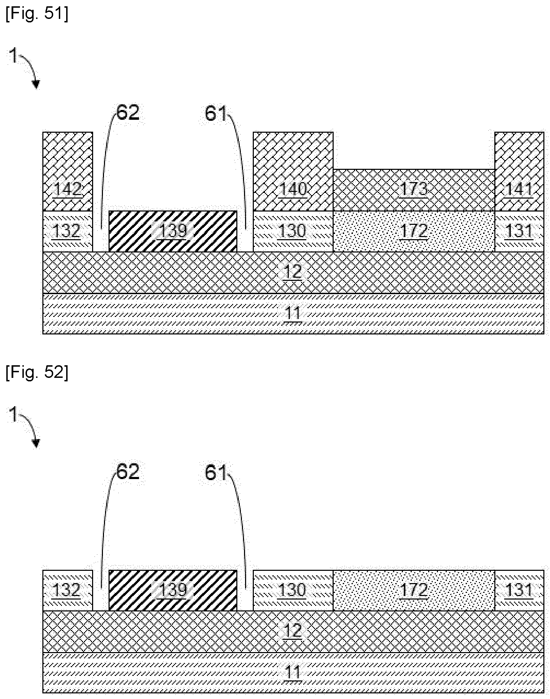

[Fig. 52] et

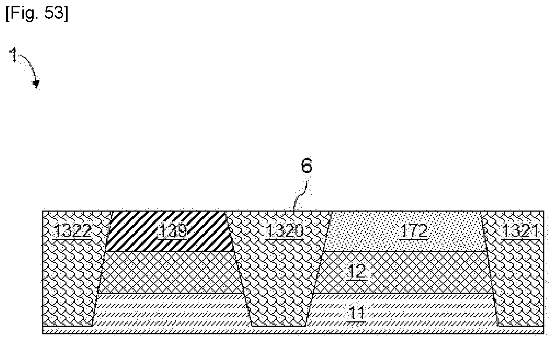

[Fig. 53] sont des vues en coupe desdits transistors nMOS et pMOS à différentes étapes de leur procédé de fabrication selon un quatrième mode de

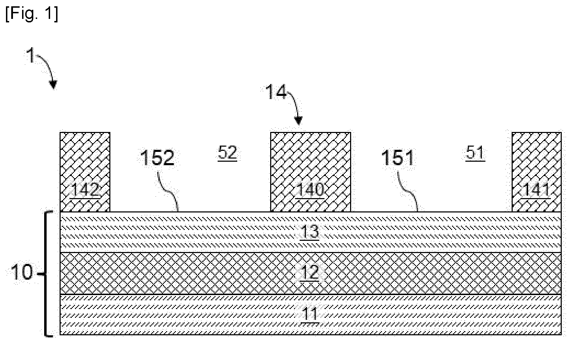

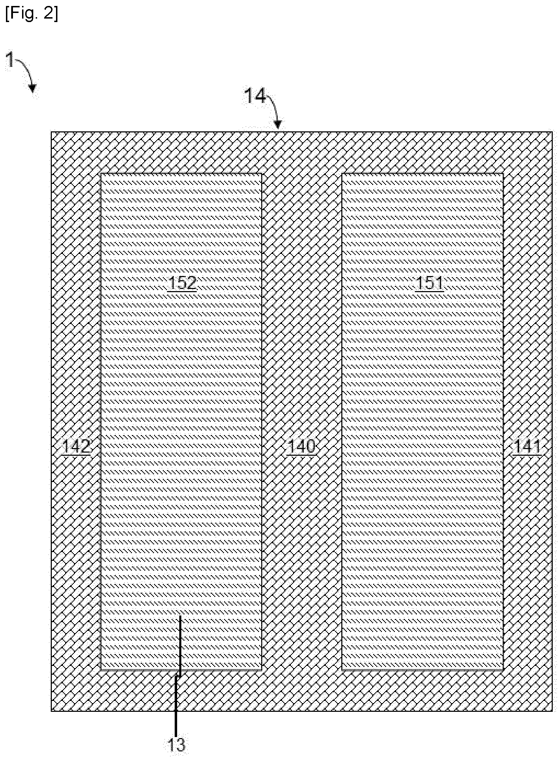

La figure 1 est une vue en coupe d'un exemple de structure 1 incluant un substrat FDSOI 10 configuré pour former des transistors nMOS et pMOS selon un procédé objet de l'invention. La figure 2 est une vue de dessus du même substrat 10.

Pour obtenir cette configuration, on fournit un substrat 10 muni d'une couche de Silicium 13, par exemple en Silicium non intentionnellement dopé. La couche de Silicium 13 présente une épaisseur typiquement comprise entre 5 et 20nm, par exemple de 6nm. La couche de Silicium 13 est ici formée sur une couche d'isolant enterrée 12, par exemple en SiO₂, d'une épaisseur typiquement comprise entre 15 et 40 nm, par exemple de 25nm. La couche d'isolant enterrée 12 est formée sur un substrat 11, typiquement en Silicium non intentionnellement dopé.

On a procédé au préalable à une étape de masquage (non représentée) de l'ensemble de la surface de la couche de Silicium 13, puis à une étape de lithographie (non représentée) pour former un masque dur 14 sur la couche de Silicium 13, et enfin à une étape de gravure (non représentée) selon le masque 14 préalablement formé. Cela a permis de dégager des ouvertures 51 et 52 et des zones associées 151 et 152 de la couche de Silicium 13 au fond des ouvertures 51 et 52. Une bande de masque dur 140 est interposée entre les zones 151 et 152. La zone 151 est interposée entre une bande 141 de masque dur et la bande 140. La zone 152 est interposée entre une bande 142 de masque dur et la bande 140. Les ouvertures 51 et 52 présentent par exemple une largeur d'au moins 60nm. Les zones 151 et 152 rendues ainsi accessibles constituent des zones de formation respectivement d'un transistor nMOS et d'un transistor pMOS.

Un procédé de fabrication qui n'est pas couvert par le texte des revendications peut être mise en œuvre à partir de l'étape 300, en partant de la configuration illustrée aux figures 1 et 2.

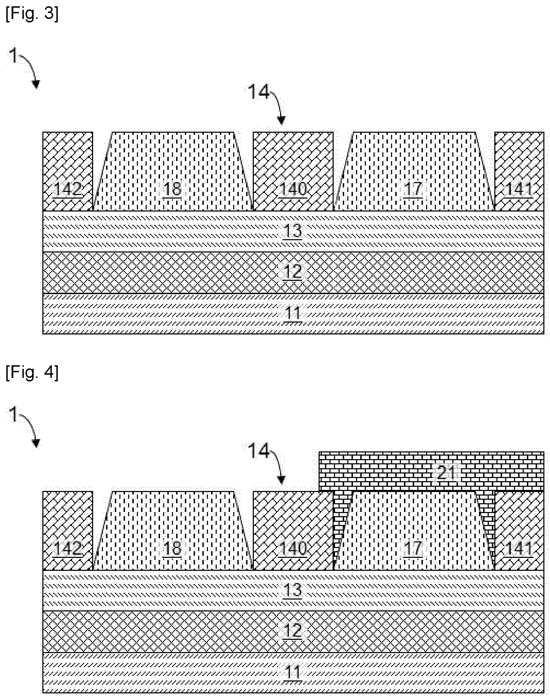

A l'étape 301, on forme dans l'ouverture 51 sur la zone 151 un premier dépôt 17 d'alliage de SiGe, comme illustré à la figure 3. On forme simultanément dans l'ouverture 52 sur la zone 152 un deuxième dépôt 18 d'alliage de SiGe. Les dépôts 17 et 18 sont typiquement formés par croissance par épitaxie avec facettes latérales. Les faces latérales des dépôts 17 et 18 sont ainsi inclinées. Des procédés de croissance de SiGe par épitaxie avec facettes sont connus en soi de l'homme du métier. Les dépôts 17 et 18 présentent typiquement une épaisseur comprise entre 5nm et 30nm. Les dépôts 17 et 18 comprennent par exemple une concentration en Germanium (en quantité d'atomes) comprise entre 15 et 35%. Le dépôt par croissance par épitaxie est par exemple réalisé avec du SiGe à 30% de Germanium, à une température de 630°C par exemple, en utilisant du H₂ comme gaz vecteur et du Germane (GeH₄) et du Dichlorosilane (DCS, SiH₂Cl₂) comme précurseurs (ou silane SiH₄).

A l'étape 302, on recouvre le premier dépôt 17 d'une couche 21 de masque dur sur l'élément 17, formant une couche de protection, comme illustré à la figure 4. La couche 21 est typiquement réalisée en SiO₂. Cette couche 21 présente par exemple une épaisseur comprise entre 15nm et 40nm.

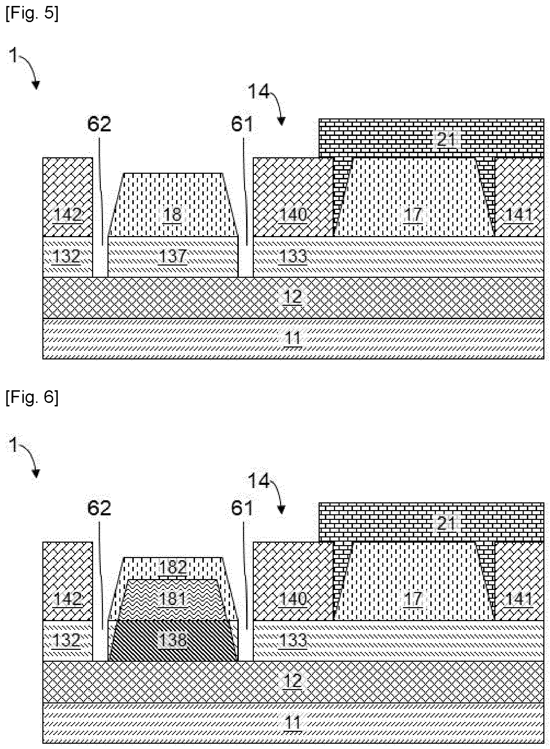

A l'étape 303, on met en œuvre une étape de gravure avantageusement anisotrope du deuxième dépôt 18 et de la couche 13. La gravure est arrêtée sur la couche 12, pour obtenir la configuration illustrée à la figure 5. Cette gravure permet de former des gorges 61 et 62, qui délimitent la couche 13 en un élément 137 et des zones 132 et 133. Dans cet exemple, une même gorge ceinture l'élément 137. La couche 12 forme alors le fond des gorges 61 et 62. La superposition du deuxième dépôt 18 et de l'élément de Si 137 forme un empilement. Les gorges 61 et 62, de part et d'autre de cet empilement, présentent typiquement une largeur comprise entre 1 et 10nm. Dans le présent exemple, la gravure des gorges 61 et 62 est aisément réalisée du fait des facettes formées lors de la formation du deuxième dépôt 18. Le deuxième dépôt 18 a ainsi une épaisseur décroissante au fur et à mesure qu'on se rapproche du masque dur 14. L'épaisseur du dépôt 18 peut par exemple être sensiblement nulle au niveau de son interface avec le masque dur 14. La gravure à proximité du masque dur 14 permet ainsi d'atteindre aisément la couche 12 autour du deuxième dépôt 18.

A l'étape 304, on procède à une implantation ionique qui amorphise en profondeur l'empilement. A partir du deuxième dépôt 18, l'amorphisation aboutit à la formation d'une couche 181 en SiGe amorphe. A partir de l'élément 137, l'amorphisation aboutit à la formation d'un élément 138 en Silicium amorphe. A la surface du deuxième dépôt 18, une couche 182 formée d'un germe cristallin de SiGe non amorphisé est conservée. La surface cristalline de l'élément 137 est également conservée sur l'élément 138 amorphe. On obtient ainsi la configuration illustrée à la figure 6. La présence des gorges 61 et 62 de part et d'autre de la couche 182 permet à la couche 182 de ne pas subir de contrainte latérale et d'adopter un état de contrainte relaxé dans un plan parallèle à la couche 12.

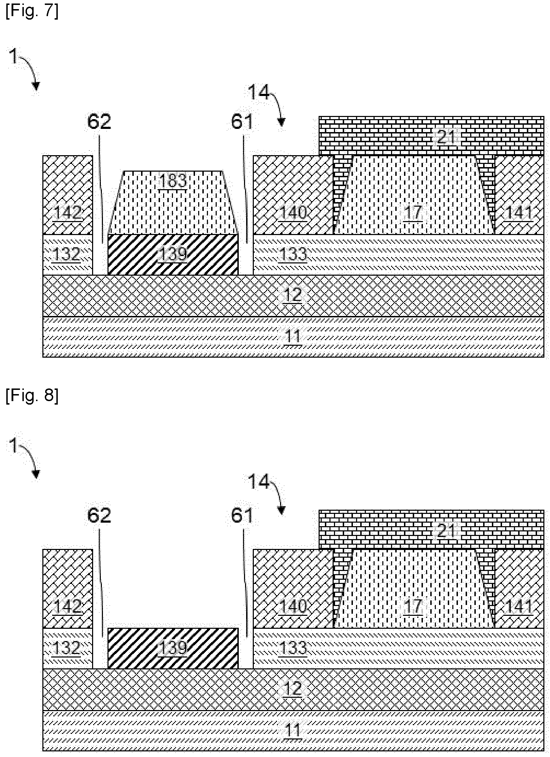

A l'étape 305, on réalise un recuit pour obtenir la recristallisation de la couche 181 ainsi que de l'élément 138. Le recuit est par exemple réalisé à une température de 600°C à 700°C, maintenue avantageusement pendant 30s à 5 min (en fonction de l'épaisseur de l'empilement de couches SiGe/Si). L'opération de recuit permet d'obtenir la configuration illustrée à la figure 7, dans laquelle s'est reformée une couche 183 de SiGe relaxé au-dessus d'un élément 139 de Si. L'élément 139 de Si prend alors le paramètre de maille de la couche 183 de SiGe relaxé et devient donc contraint en tension dans un plan parallèle à la couche 12.

A l'étape 306, on procède au retrait de la couche 183 de SiGe relaxé par gravure, ce qui permet d'obtenir la configuration illustrée à la figure 8. L'élément 139 en Silicium conserve une contrainte en tension dans un plan parallèle à la couche 12.

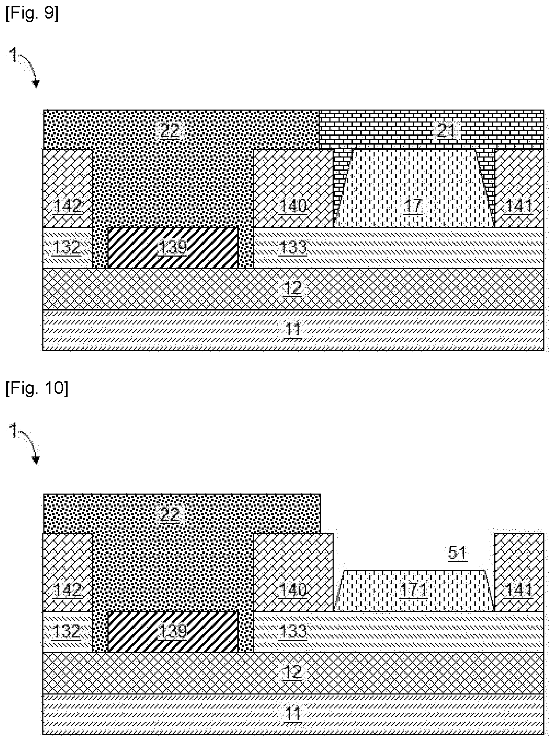

A l'étape 307, on forme une couche 22 de masque dur sur l'élément 139, comme illustré figure 9. La couche 22 forme une couche de protection. L'élément 139 est alors protégé lors des étapes ultérieures de gravure. La deuxième couche de protection 22 est typiquement réalisée en SiN. Cette couche 22 présente par exemple une épaisseur comprise entre 30 et 50nm. L'épaisseur de la couche 22 formée est suffisante pour dépasser le sommet de la couche 21.

A l'étape 308, on met en œuvre une étape de gravure avantageusement anisotrope de la couche de protection 21 et du premier dépôt 17. On forme ainsi un élément 171 de SiGe accessible par l'ouverture 51. On obtient ainsi la configuration illustrée à la figure 10.

A l'étape 309, on réalise un recuit par oxydation thermique de l'élément SiGe 171. Ce recuit provoque la diffusion du Germanium de l'élément 171 vers la couche 13 de Silicium, ce qui aboutit à la formation dans la couche 13 des éléments suivants :
- un élément 172 de SiGe, formé par enrichissement en Germanium de la couche 13 ;
- des zones 130 et 131 résiduelles de Si. Les zones 130 et 131 sont disposées à la verticale des bandes 140 et 141 de la couche de masque dur.

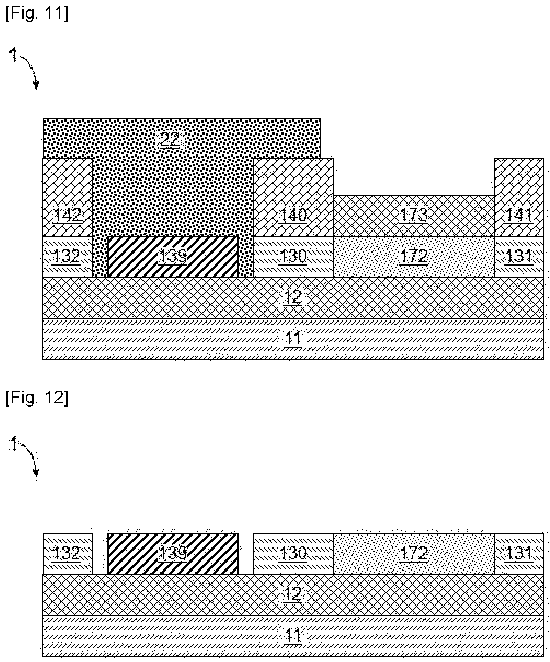

La surface supérieure de l'élément 172 est recouverte d'une couche 173 de SiO₂, obtenue par oxydation thermique de l'élément 171. La configuration obtenue est illustrée à la figure 11. L'élément 172 de SiGe conserve les paramètres de maille de la couche de Silicium 13 d'origine dans le plan. La diffusion du Germanium dans la couche de Silicium 13 conduit à créer une contrainte en compression de façon biaxiale dans un plan parallèle à la couche d'isolant 12 dans l'élément 172 formé. La limite entre l'élément 172 et les zones 130 et 131 est positionnée sensiblement à la verticale des faces latérales des bandes 140 et 141 respectivement. La superposition de l'élément de SiGe 172 et de la couche de SiO₂ 173 forme un empilement.

A l'étape 310, on procède au retrait de la couche 173 de SiO₂, de la couche de protection 22 et des bandes 140, 141 et 142, comme illustré à la figure 12. On fournit ainsi un accès à l'élément de SiGe 172 d'une part et à l'élément 139 d'autre part.

A l'étape 311, on procède au retrait des éléments 130, 131 et 132 pour former des gorges par gravure. Les gorges sont alors remplies de matériau isolant pour former des éléments 1320, 1321 et 1322. Cela permet de former des tranchées d'isolation profondes, généralement désignées par le terme STI (pour Shallow Trench Isolation en langue anglaise), comme illustré à la figure 13. On forme ainsi une isolation entre une zone de formation de transistors pMOS et une zone de formation de transistors nMOS.

Ainsi, à l'issue du procédé des étapes d'un procédé de fabrication selon un premier mode de réalisation, on dispose :
- d'un élément 172 en SiGe contraint en compression pour la formation du canal de transistors pMOS dans une zone. ;
- d'un élément 139 en Silicium contraint en tension pour la formation du canal de transistors nMOS dans l'autre zone.

D'autres zones de la structure peuvent présenter une couche de Silicium non contraint pour la formation d'autres transistors.

Les éléments 172 et 139 sont obtenus à partir d'un même dépôt initial de SiGe par épitaxie, avec un nombre réduit d'étapes de masquage et de photolithographie.

La figure 14 est un diagramme illustrant les étapes du procédé de fabrication selon le premier mode de réalisation, comme détaillé précédemment.

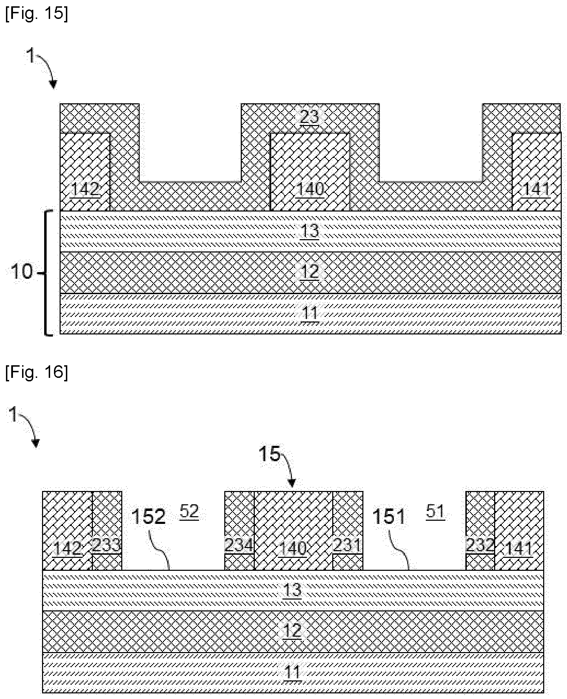

La figure 15 est une vue en coupe d'un exemple de structure 1 à une étape d'un procédé de fabrication, selon l'invention revendiquée **On fournit** initialement un substrat FDSOI 10 configuré pour former des transistors nMOS et pMOS conformément aux figures 1 et 2 précédemment décrites.

On a procédé à un dépôt conforme d'une couche diélectrique 23 uniforme sur la surface supérieure de la structure 1. La couche 23 est par exemple réalisée en SiO₂, ce qui permet de contrôler parfaitement son épaisseur.

On procède ensuite à une gravure, avantageusement anisotrope de type plasma en chimie fluorocarbonée, de la couche 23, comme illustré à la figure 16. Cela a permis de dégager des ouvertures 51 et 52 et des zones associées 151 et 152 de la couche de Silicium 13 au fond des ouvertures 51 et 52.

Une bande de masque dur 140 est interposée entre les zones 151 et 152. Un espaceur 231, reliquat de la gravure de la couche 23 et accolé à la bande 140, est interposé entre la bande 140 et la zone 151. Un espaceur 234, reliquat de la gravure de la couche 23 et accolé à la bande 140, est interposé entre la bande 140 et la zone 152.

La zone 151 est interposée entre une bande 141 de masque dur et la bande 140. Un espaceur 232, reliquat de la gravure de la couche 23 et accolé à la bande 141, est interposé entre la bande 141 et la zone 151.

La zone 152 est interposée entre une bande 142 de masque dur et la bande 140. Un espaceur 233, reliquat de la gravure de la couche 23 et accolé à la bande 142, est interposé entre la bande 142 et la zone 152.

Les ouvertures 51 et 52 présentent par exemple une largeur d'au moins 40nm. Les zones 151 et 152 rendues ainsi accessibles constituent des zones de formation respectivement d'un transistor nMOS et d'un transistor pMOS.

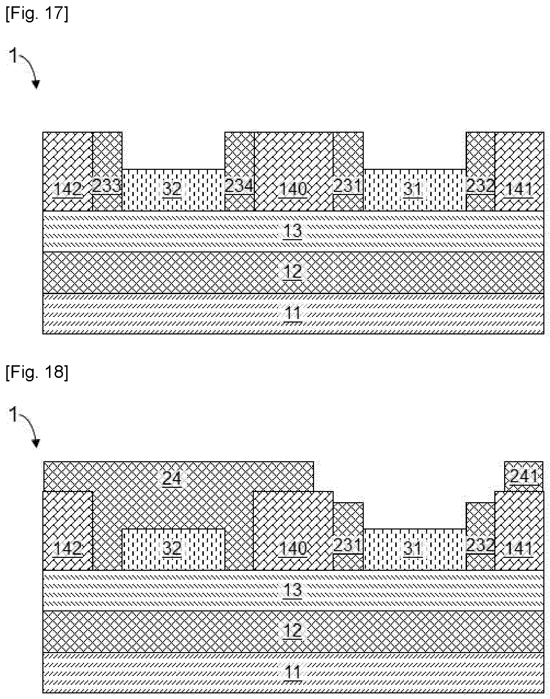

On forme ensuite dans l'ouverture 51 sur la zone 151 un premier dépôt 31 en alliage de SiGe, comme illustré à la figure 17. On forme simultanément dans l'ouverture 52 sur la zone 152 un deuxième dépôt 32 en alliage de SiGe. Les dépôts 31 et 32 sont typiquement formés par croissance par épitaxie. Des procédés de croissance de SiGe par épitaxie sont connus en soi de l'homme du métier. Les dépôts 31 et 32 présentent typiquement une épaisseur comprise entre 5nm et 30nm. Les dépôts 31 et 32 comprennent par exemple une concentration en Germanium (en quantité d'atomes) comprise entre 15 et 35%. Le dépôt par croissance par épitaxie est par exemple réalisé avec du SiGe à 30% de Germanium, à une température de 630°C par exemple, en utilisant du H₂ comme gaz vecteur et du Germane (GeH₄) et du Dichlorosilane (DCS, SiH₂Cl₂) comme précurseurs (ou silane SiH₄).

Comme illustré à la figure 18, on recouvre ensuite d'une couche 24 de masque dur le deuxième dépôt 32. La couche 24 forme une couche de protection. La couche 24 est ici confondue avec les espaceurs 233 et 234, les couches 23 et 24 étant ici dans un même matériau. Le deuxième dépôt 32 est ainsi protégé lors des étapes ultérieures de gravure par cette couche de protection. Simultanément, on dépose également une couche de masque dur 241 sur la bande 141. Les couches 24 et 241 sont typiquement réalisées en SiO₂. Ces couches 24 et 241 présentent par exemple une épaisseur comprise entre 10 et 40nm.

On réalise ensuite un recuit par oxydation thermique du premier dépôt de SiGe 31. Ce recuit provoque la diffusion du Germanium du premier dépôt 31 vers la couche 13 de Silicium, ce qui aboutit à la formation dans ladite couche 13 des éléments suivants :
- un élément 34 de SiGe, formé par enrichissement en Ge de la couche 13 ;
- des zones 131 et 134 résiduelles de Si. La zone 131 est disposée à la verticale de la bande 141 de la couche de masque dur. La zone 134 s'étend quant à elle à partir de la verticale de la bande 140.

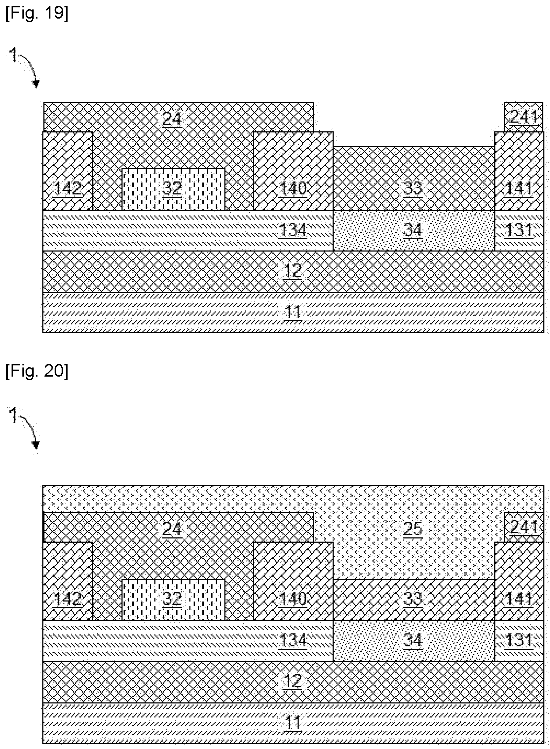

La surface supérieure de l'élément 34 est recouverte d'une couche 33 de SiO₂, obtenue par oxydation thermique du premier dépôt 31 et liaison avec les espaceurs 231 et 232. La configuration obtenue est illustrée à la figure 19. L'élément 34 de SiGe conserve les paramètres cristallins de la couche de Silicium 13 d'origine. La condensation du Germanium dans la couche de Silicium 13 conduit à créer une contrainte en compression de façon biaxiale dans un plan parallèle à la couche d'isolant 12 dans l'élément 34 formé. La limite entre l'élément 34 et les zones 131 et 134 est positionnée sensiblement à la verticale des faces latérales des bandes 141 et 140 respectivement. La superposition de l'élément 34 et de la couche 33 forme un empilement.

Comme illustré à la figure 20, on procède ensuite au dépôt d'une couche 25 pleine plaque. La couche 25 est typiquement réalisée en Carbone type SOC ou un masque dur enrichi au silicium avec masque dur anti-réflexion.

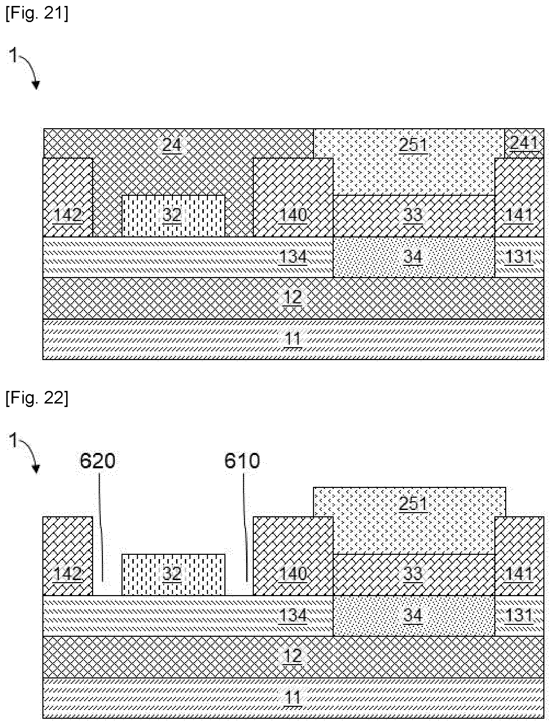

La couche 25 précédemment formée subit ensuite une gravure ou polissage mécanochimique, avec arrêt sur les couches de masque dur 24 et 241, comme illustré à la figure 21. On forme ainsi l'élément 251, reliquat de la gravure de la couche 25. L'élément 251 forme une couche de protection et protège ainsi la couche 33 de SiO₂ et l'élément 34 de SiGe des étapes ultérieures de gravure.

On procède alors au retrait des couches de masque dur 24 et 241 par gravure sélective, libérant ainsi l'accès au deuxième dépôt 32 précédemment formé. On fournit ainsi transitoirement un accès au deuxième dépôt 32. Cette gravure est ensuite poursuivie pour former des gorges 610 et 620, qui séparent le deuxième dépôt 32 respectivement de la bande 140 et de la bande 142. La couche 134 forme alors le fond des gorges 610 et 620. On obtient la configuration illustrée à la figure 22.

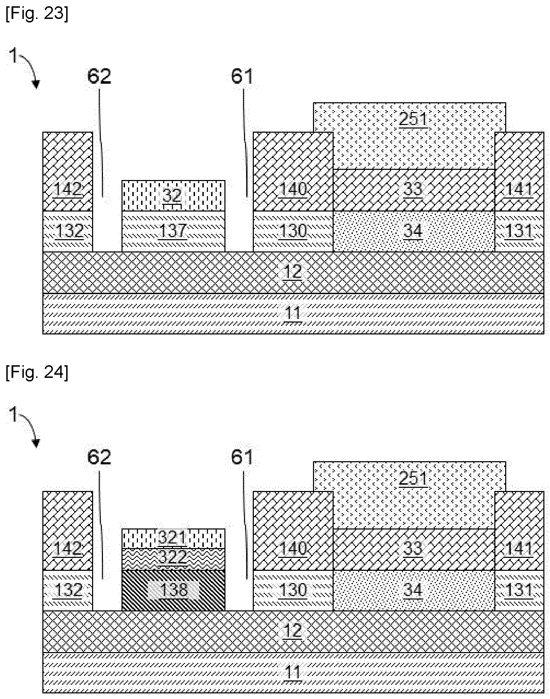

On met ensuite en œuvre une étape de gravure avantageusement anisotrope de la couche 134, autour du deuxième dépôt 32, arrêtée sur la couche 12, pour obtenir la configuration illustrée figure 23. Cette gravure permet de former les gorges 61 et 62, dans le prolongement des gorges 610 et 620. Les gorges 61 et 62 séparent un élément 137 et de zones 132 et 130. Dans cet exemple, une même gorge ceinture l'élément 137. La couche 12 forme alors le fond des gorges 61 et 62. La superposition du deuxième dépôt 32 et de l'élément 137 forme un empilement dit deuxième empilement. Les gorges 61 et 62 présentent typiquement une largeur comprise entre 1 et 10nm. Dans le présent exemple, la gravure des gorges 61 et 62 est aisément réalisée du fait de la réalisation préalable des gorges 610 et 620. Les gorges 610 et 620 forment un bon point de départ pour atteindre aisément la couche 12 autour du deuxième dépôt 32.

On procède alors à une implantation ionique qui amorphise l'empilement du dépôt 32 et de l'élément 137 en profondeur. A partir du dépôt 32, l'amorphisation aboutit à la formation d'une couche 322 en SiGe amorphe. A partir de l'élément 137, l'amorphisation aboutit à la formation d'un élément 138 en Silicium amorphe. A la surface du dépôt 32, une couche 321 formée d'un germe cristallin de SiGe non amorphisé est conservée. On obtient ainsi la configuration illustrée à la figure 24. La présence des gorges 61 et 62 de part et d'autre de la couche 321 permet à ladite couche 321 de ne pas subir de contrainte latérale et d'adopter un état de contrainte relaxé dans un plan parallèle à la couche 12.

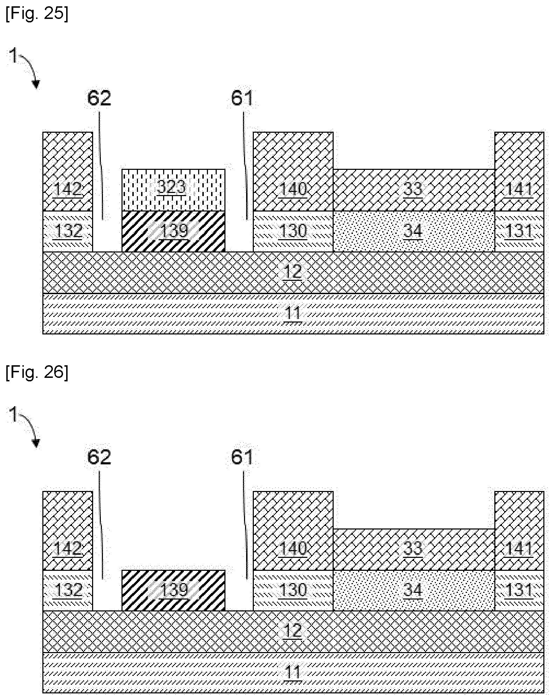

On procède alors au retrait de la couche de protection 251. Simultanément, on réalise également un recuit de recristallisation pour obtenir la recristallisation de la couche 322 et de la couche 138. Le recuit est par exemple réalisé à une température de 600°C à 700°C, maintenue avantageusement pendant 30s à 5 min selon l'épaisseur de l'empilement SiGe/Si. L'opération de recuit permet d'obtenir la configuration illustrée à la figure 25, dans laquelle s'est formée une couche 323 de SiGe relaxé au-dessus d'un élément 139 de Si cristallin. L'élément 139 de Si prend alors le paramètre de maille de la couche 323 de SiGe relaxé et devient donc contraint en tension dans un plan parallèle à la couche 12.

On procède ensuite au retrait par gravure de la couche 323 de SiGe relaxé, ce qui permet d'obtenir la configuration illustrée à la figure 26. L'élément 139 en Silicium conserve une contrainte en tension dans un plan parallèle à la couche 12.

Comme illustré à la figure 27, on procède ensuite au retrait de la couche 33 de SiO₂ et des bandes 140, 141 et 142. On fournit ainsi un accès à l'élément en Si 139 d'une part et à l'élément 34 en SiGe d'autre part.

On procède enfin au retrait des éléments 130, 131 et 132 pour former des gorges par gravure. Les gorges sont alors remplies de matériau isolant pour former des éléments 1320, 1321 et 1322. Cela permet de former des tranchées d'isolation profondes, généralement désignées par le terme STI (pour Shallow Trench Isolation en langue anglaise), comme illustré à la figure 28. On forme ainsi une isolation entre une première zone de formation de transistors pMOS et une deuxième zone de formation de transistors nMOS.

Ainsi, à l'issue du procédé des étapes d'un procédé de fabrication selon un deuxième mode de réalisation, on dispose :
- d'un élément 34 en SiGe contraint en compression pour la formation du canal de transistors pMOS dans la première zone ;
- d'un élément 139 en Silicium contraint en tension pour la formation du canal de transistors nMOS dans la deuxième zone.

par épitaxie, avec un nombre réduit d'étapes de masquage et de photolithographie.

D'autres zones de la structure peuvent présenter une couche de Silicium non contraint pour la formation d'autres transistors.

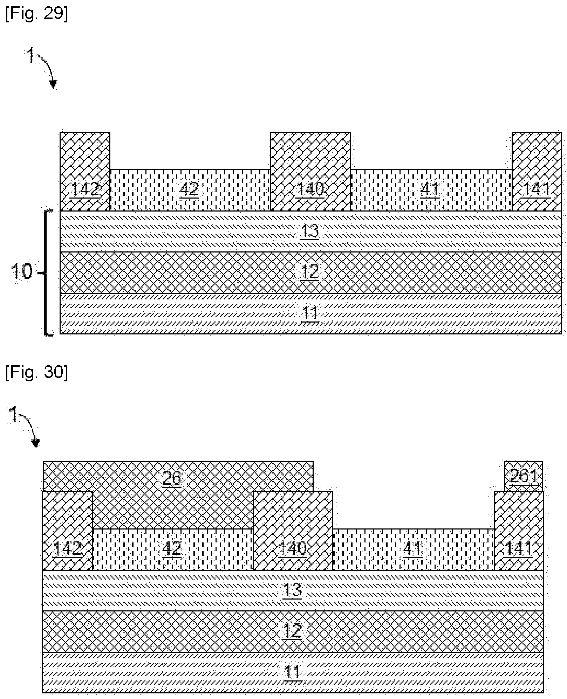

La figure 29 est une vue en coupe d'un exemple de structure 1 à une étape d'un procédé de fabrication, selon un troisième mode de réalisation qui n'est pas couvert par le texte des revendications On fournit initialement un substrat FDSOI 10 configuré pour former des transistors nMOS et pMOS conformément aux figures 1 et 2 précédemment décrites.

On a formé dans l'ouverture 51 sur la zone 151 un premier dépôt 41 en alliage de SiGe, comme illustré à la figure 29. On a formé simultanément dans l'ouverture 52 sur la zone 152 un deuxième dépôt 42 en alliage de SiGe. Les dépôts 41 et 42 sont typiquement formés par croissance par épitaxie. Des procédés de croissance de SiGe par épitaxie sont connus en soi de l'homme du métier. Les dépôts 41 et 42 présentent typiquement une épaisseur comprise entre 5nm et 30nm. Les dépôts 41 et 42 comprennent par exemple une concentration en Germanium (en quantité d'atomes) comprise entre 15 et 35%. Le dépôt par croissance par épitaxie est par exemple réalisé avec du SiGe à 30% de Germanium, à une température de 630°C par exemple, en utilisant du H₂ comme gaz vecteur et du Germane (GeH₄) et du Dichlorosilane (DCS, SiH₂Cl₂) comme précurseurs (ou silane SiH₄).

Comme illustré à la figure 30, on recouvre ensuite d'une couche 26 de masque dur, formant une couche de protection, le deuxième dépôt 42. Le deuxième dépôt 42 est alors protégé lors des étapes ultérieures de gravure. Simultanément, on dépose également une couche de masque dur 261 sur la bande 141. Les couches 26 et 261 sont typiquement réalisées en SiO₂. Ces couches 26 et 261 présentent par exemple une épaisseur comprise entre 10 et 40nm.

On réalise ensuite un recuit par oxydation thermique du premier dépôt SiGe 41. Ce recuit provoque la diffusion du Germanium du premier dépôt 41 vers la couche 13 de Silicium, ce qui aboutit à la formation dans ladite couche 13 des éléments suivants :
- un élément 44 de SiGe, formé par enrichissement en Ge de la couche 13 ;
- des zones 131 et 134 résiduelles de Si. La zone 131 est disposée à la verticale de la bande 141 de la couche de masque dur. La zone 134 s'étend quant à elle à partir de la verticale de la bande 140.

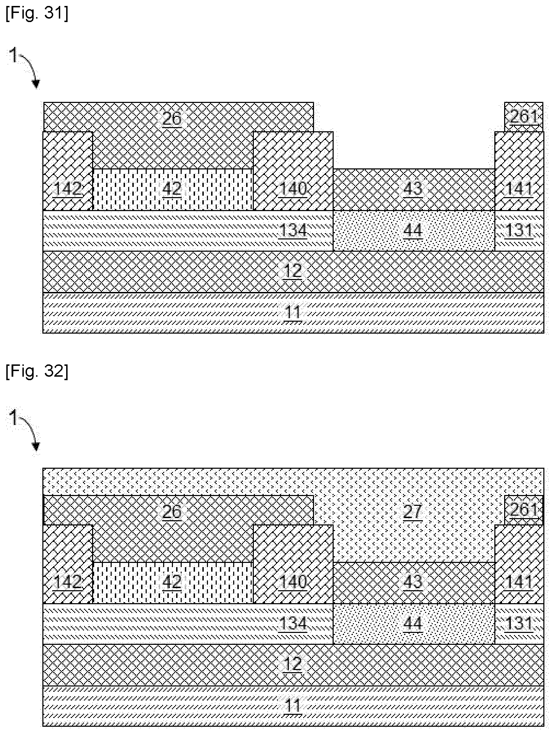

La surface supérieure de l'élément 44 est recouverte d'une couche 43 de SiO₂, obtenue par oxydation thermique du premier dépôt 41. La configuration obtenue est illustrée à la figure 31. L'élément 44 de SiGe conserve les paramètres de maille de la couche de Silicium 13 d'origine dans son plan. La condensation du Germanium dans la couche de Silicium 13 conduit à créer une contrainte en compression de façon biaxiale dans un plan parallèle à la couche d'isolant 12 dans l'élément 44 formé. La limite entre l'élément 44 et les zones 131 et 134 est positionnée sensiblement à la verticale des faces latérales des bandes 141 et 140 respectivement. La superposition de l'élément 44 et de la couche 43 forme un empilement.

Comme illustré à la figure 32, on procède ensuite au dépôt d'une couche 27 pleine plaque. La couche 27 est typiquement réalisée en Carbone type SOC ou un masque dur enrichi au silicium avec masque dur anti-réflexion.

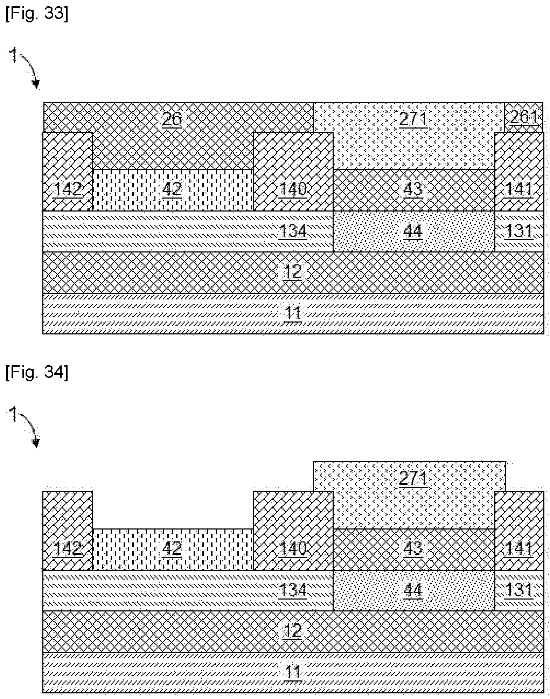

La couche 27 précédemment formée subit ensuite une gravure ou de polissage mécanochimique, avec arrêt sur les couches de masque dur 26 et 261, comme illustré à la figure 33. On forme ainsi l'élément 271, à partir de la couche 27. L'élément 271 forme ainsi une couche de protection, qui protège ainsi le premier empilement des étapes ultérieures de gravure.

On procède alors au retrait des couches de masque dur 26 et 261 par gravure sélective, libérant ainsi l'accès du deuxième dépôt 42 précédemment formé, comme illustré à la figure 34.

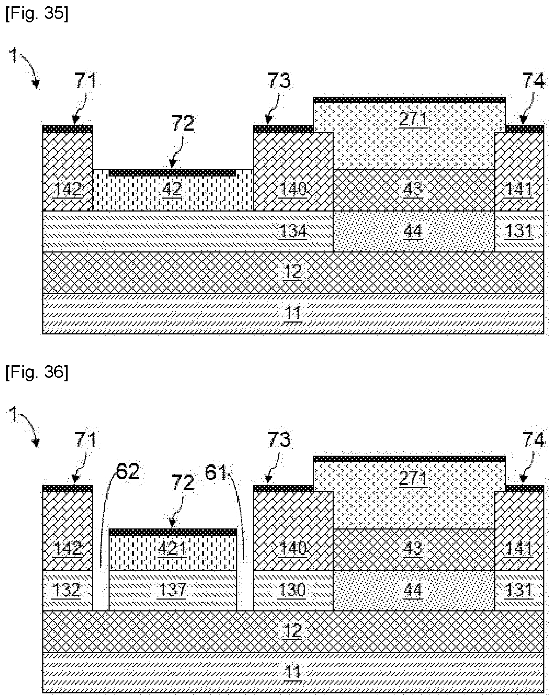

On met ensuite en œuvre un procédé d'implantation inclinée, par exemple d'espèce C (Carbone) ou O (Oxygène) selon au moins 2 directions inclinées différentes. L'implantation peut avantageusement être réalisée dans 4 directions inclinées, incluses dans deux plans perpendiculaires. L'inclinaison permet de bénéficier d'un effet d'ombrage dû à une hauteur supérieure des bandes 140 et 142 par rapport au dépôt 42. Suite à cette opération, on obtient la configuration illustrée à la figure 35. Une forte concentration d'ions implantés est ainsi présente dans une zone 71 en surface de la bande 142. Une forte concentration d'ions implantés est également présente dans une zone 72 en surface du deuxième dépôt 42 et dans une zone 73 en surface. Une forte concentration d'ions implantés est enfin présente dans une zone 74 en surface de la bande 141 ainsi qu'en surface et sur les faces latérales de l'élément 271.

On met ensuite en œuvre une étape de gravure avantageusement anisotrope du deuxième dépôt 42 et de la couche 13. La gravure est arrêtée sur la couche 12, pour obtenir la configuration illustrée à la figure 36. Cette gravure permet de former un élément 421, reliquat du deuxième dépôt 42. Cette gravure permet également de former des gorges 61 et 62, qui délimitent la couche 13 en un élément 137 et des zones 130 et 132. Dans cet exemple, une même gorge ceinture l'élément 137. La couche 12 forme alors le fond des gorges 61 et 62. La superposition des éléments 142 et 137 forme un empilement. Les gorges 61 et 62 présentent typiquement une largeur comprise entre 1 et 10nm. Dans le présent exemple, la gravure des gorges 61 et 62 est aisément réalisée du fait de l'absence initiale d'implant en surface du deuxième dépôt 42 à la jonction dudit deuxième dépôt 42 et des bandes 140 d'une part et 142 d'autre part.

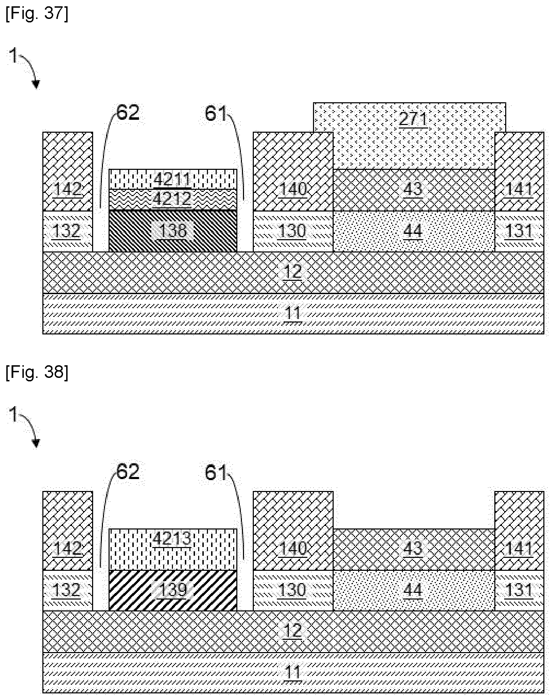

On procède alors à une implantation ionique qui amorphise l'élément 421 en profondeur, ce qui aboutit à la formation d'une couche 4212 en SiGe amorphe. L'implantation ionique amorphise également l'élément 137, ce qui aboutit à la formation d'un élément 138 en Silicium amorphe. A la surface de l'élément 421, une couche 4211 formée d'un germe cristallin de SiGe non amorphisé est conservée. On obtient ainsi la configuration illustrée à la figure 37. La présence des gorges 61 et 62 de part et d'autre de la couche 4211 permet à ladite couche 4211 de ne pas subir de contrainte latérale et d'adopter un état de contrainte relaxé dans un plan parallèle à la couche 12.

On procède alors au retrait de la première couche de protection 271. Simultanément, on réalise également un recuit pour la recristallisation de la couche 4212 ainsi que de l'élément 138. Le recuit est par exemple réalisé à une température de 600°C à 700°C, maintenue avantageusement 30s à 5 min selon l'épaisseur de l'empilement SiGe/Si. L'opération de recuit permet d'obtenir la configuration illustrée à la figure 38, dans laquelle s'est reformée une couche 4213 de SiGe relaxé au-dessus d'un élément 139 de Si cristallin. L'élément 139 de Si prend alors le paramètre de maille de la couche 4213 de SiGe relaxé et devient donc contraint en tension dans un plan parallèle à la couche 12.

On procède ensuite au retrait de la couche 4213 de SiGe relaxé par gravure, ce qui permet d'obtenir la configuration illustrée à la figure 39. L'élément 139 en Silicium conserve une contrainte en tension dans un plan parallèle à la couche 12.

Comme illustré à la figure 40, on procède ensuite au retrait de la couche 43 de SiO₂ et des bandes 140, 141 et 142. On fournit ainsi un accès à l'élément de SiGe 44 d'une part et à l'élément de Si 139 d'autre part.

On procède enfin au retrait des éléments 130, 131 et 132 pour former des gorges par gravure. Les gorges sont alors remplies de matériau isolant pour former des éléments 1320, 1321 et 1322. Cela permet de former des tranchées d'isolation profondes, généralement désignées par le terme STI (pour Shallow Trench Isolation en langue anglaise), comme illustré à la figure 41. On forme ainsi une isolation entre une première zone de formation de transistors pMOS et une deuxième zone de formation de transistors nMOS.

Ainsi, à l'issue du procédé des étapes d'un procédé de fabrication selon un troisième mode de réalisation, on dispose :
- d'un élément 44 en SiGe contraint en compression pour la formation du canal de transistors pMOS dans la première zone ;
- d'un élément 139 en Silicium contraint en tension pour la formation du canal de transistors nMOS dans la deuxième zone.

D'autres zones de la structure peuvent présenter une couche de Silicium non contraint pour la formation d'autres transistors.

Les éléments 44 et 139 sont obtenus à partir d'un même dépôt initial de SiGe par épitaxie, avec un nombre réduit d'étapes de masquage et de photolithographie.

La figure 42 est une vue en coupe d'un exemple de structure 1 à une étape d'un procédé de fabrication, selon un quatrième mode de réalisation. On fournit initialement un substrat FDSOI 10 configuré pour former des transistors nMOS et pMOS conformément aux figures 1 et 2 précédemment décrites. Dans ce mode de réalisation, on inverse l'ordre des masquages des zones de formation des transistors nMOS et pMOS par rapport aux premier à troisième modes de réalisation.

On a formé dans l'ouverture 51 sur la zone 151 un premier dépôt 17 en alliage de SiGe, comme illustré à la figure 42. On a formé simultanément dans l'ouverture 52 sur la zone 152 un deuxième dépôt 18 en alliage de SiGe. Les dépôts 17 et 18 sont typiquement formés par croissance par épitaxie avec facettes latérales. Les faces latérales des dépôts 17 et 18 sont ainsi inclinées. Des procédés de croissance de SiGe par épitaxie avec facettes sont connus en soi de l'homme du métier. Les dépôts 17 et 18 présentent typiquement une épaisseur comprise entre 5nm et 30nm. Les dépôts 17 et 18 comprennent par exemple une concentration en Germanium (en quantité d'atomes) comprise entre 15 et 35%. Le dépôt par croissance par épitaxie est par exemple réalisé avec du SiGe à 30% de Germanium, à une température de 630°C par exemple, en utilisant du H₂ comme gaz vecteur et du Germane (GeH₄) et du Dichlorosilane (DCS, SiH₂Cl₂) comme précurseurs (ou silane SiH₄).

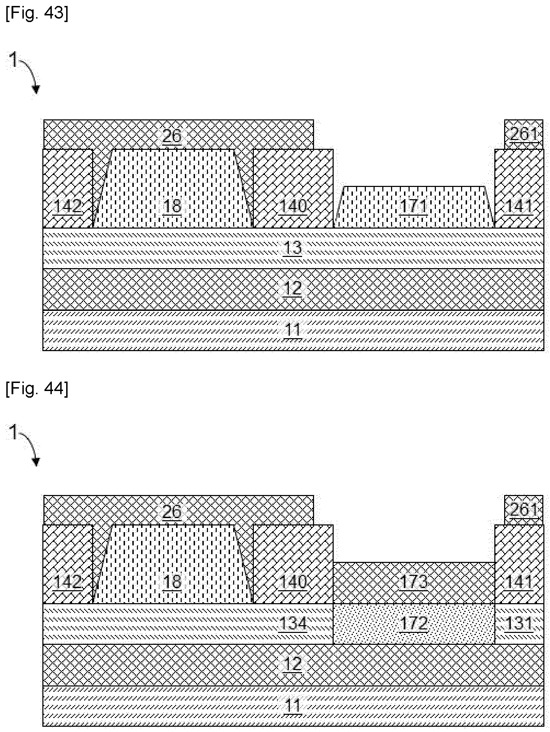

Comme illustré à la figure 43, on recouvre ensuite le deuxième dépôt 18 d'une couche 26 de masque dur. La couche 26 forme une couche de protection. Le deuxième dépôt 18 est ainsi protégé lors des étapes ultérieures de gravure. Simultanément, on recouvre également la bande 141 d'une couche de masque dur 261. Les couches 26 et 261 sont typiquement réalisées en SiO₂. Ces couches 26 et 261 présentent par exemple une épaisseur comprise entre 10 et 40nm.

Simultanément, on procède à une gravure partielle du premier dépôt 17, pour aboutir à la formation d'un élément 171, dont l'épaisseur est avantageusement comprise entre 5 et 15nm.

On réalise ensuite un recuit par oxydation thermique de l'élément de SiGe 171. Ce recuit provoque la diffusion du Germanium de l'élément 171 vers la couche 13 de Silicium, ce qui aboutit à la formation dans ladite couche 13 des éléments suivants :
- un élément 172 de SiGe, formé par enrichissement en Ge de la couche 13 ;
- des zones 131 et 134 résiduelles de Si. La zone 131 est disposée à la verticale de la bande 141 de la couche de masque dur. La zone 134 s'étend quant à elle à **partir** de la verticale de la bande 140.

La surface supérieure de l'élément 172 est recouverte d'une couche 173 de SiO₂, obtenue par oxydation thermique de l'élément 171. La configuration obtenue est illustrée à la figure 44. La superposition de l'élément 172 et de la couche 173 forme un empilement. L'élément 172 de SiGe conserve les paramètres cristallins de la couche de Silicium 13 d'origine. La condensation du Germanium dans la couche de Silicium 13 conduit à créer une contrainte en compression de façon biaxiale dans un plan parallèle à la couche d'isolant 12 dans l'élément 172 formé. La limite entre l'élément 172 et les zones 131 et 134 est positionnée sensiblement à la verticale des faces latérales des bandes 141 et 140 respectivement.

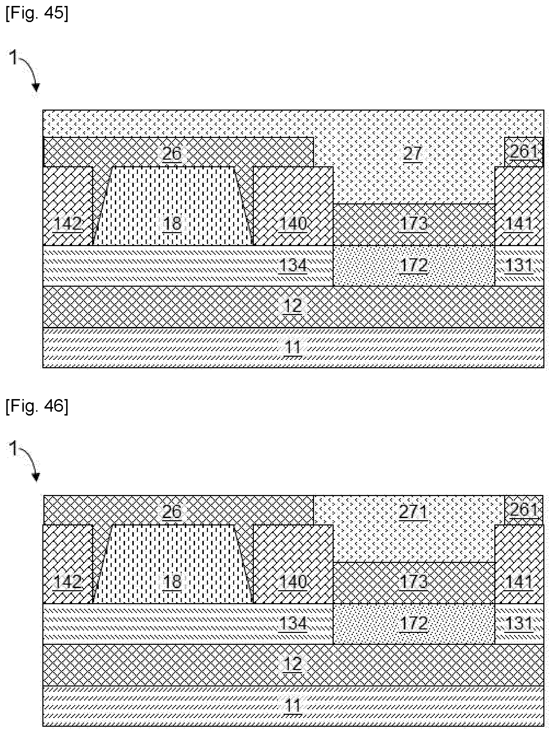

Comme illustré à la figure 45, on procède ensuite au dépôt d'une couche 27 pleine plaque. La couche 27 est typiquement réalisée en Carbone type SOC ou un masque dur enrichi au silicium avec masque dur anti-réflexion.

La couche 27 précédemment formée subit ensuite une gravure ou un polissage mécano chimique, avec arrêt sur les couches de masque dur 26 et 261, comme illustré à la figure 46. On forme ainsi l'élément 271, reliquat de la couche 27. L'élément 271 forme une couche de protection, qui protège ainsi la couche 173 de SiO₂ et l'élément 172 de SiGe des étapes ultérieures de gravure.

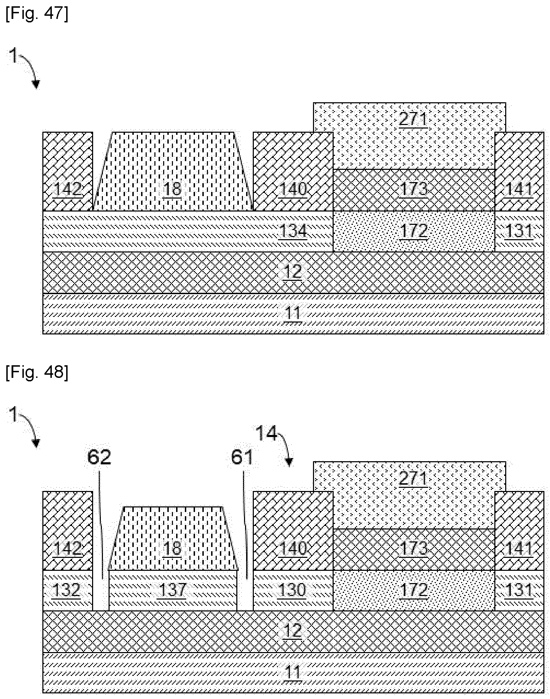

On procède alors au retrait de la deuxième couche de protection 26 et de la couche de masque dur 261 par gravure, libérant ainsi l'accès au deuxième dépôt 18 précédemment formé, comme illustré à la figure 47.

On met alors en œuvre une étape de gravure avantageusement anisotrope du deuxième dépôt 18 et de la couche 13. La gravure est arrêtée sur la couche 12, pour obtenir la configuration illustrée à la figure 48. Cette gravure permet de former des gorges 61 et 62, qui délimitent la couche 13 en un élément 137 et des zones 130 et 132. Dans cet exemple, une même gorge ceinture l'élément 137. La couche 12 forme alors le fond des gorges 61 et 62. La superposition du deuxième dépôt 18 et de l'élément 137 forme un empilement. Les gorges 61 et 62 présentent typiquement une largeur comprise entre 1 et 10nm. Dans le présent exemple, la gravure des gorges 61 et 62 est aisément réalisée du fait des facettes formées lors de la formation du deuxième dépôt 18. Le deuxième dépôt 18 a ainsi une très faible épaisseur à proximité du masque dur 14. La gravure à proximité du masque dur 14 permet ainsi d'atteindre aisément la couche 12 autour du deuxième dépôt 18.

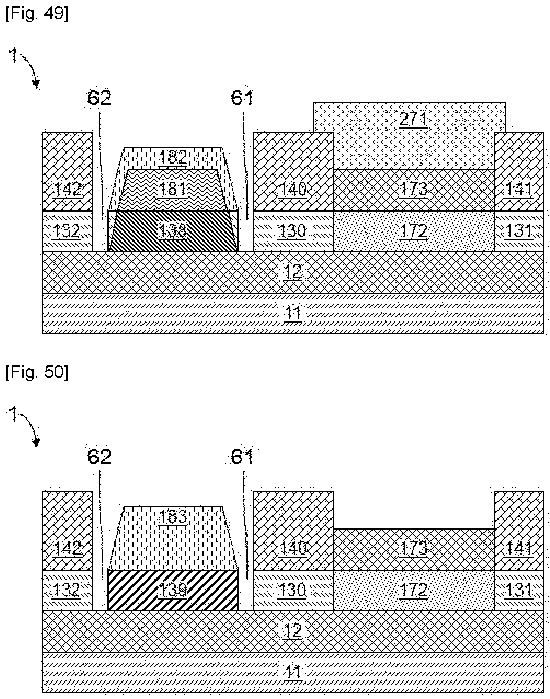

On procède ensuite à une implantation ionique qui amorphise le deuxième empilement en profondeur. L'amorphisation du deuxième dépôt 18 aboutit à la formation d'une couche 181 en SiGe amorphe. L'amorphisation de l'élément 137 aboutit à la formation d'un élément 138 en Silicium amorphe. A la surface du deuxième dépôt 18, une couche 182 formée d'un germe cristallin de SiGe non amorphisé est conservée. On obtient ainsi la configuration illustrée à la figure 49. La présence des gorges 61 et 62 de part et d'autre de la couche 182 permet à ladite couche 182 de ne pas subir de contrainte latérale et d'adopter un état de contrainte relaxé dans un plan parallèle à la couche 12.

On réalise ensuite un recuit pour obtenir la recristallisation de la couche 181 ainsi que de l'élément 138. Le recuit est par exemple réalisé à une température de 600°C à 700°C, maintenue avantageusement pendant 30s à 5 min selon l'épaisseur de l'empilement SiGe/Si. L'opération de recuit permet d'obtenir la configuration illustrée à la figure 50, dans laquelle s'est reformée une couche 183 de SiGe relaxé au-dessus d'un élément 139 de Si cristallin. L'élément 139 de Si prend alors le paramètre de maille de la couche 183 de SiGe relaxé et devient donc contraint en tension dans un plan parallèle à la couche 12.

On procède alors au retrait de la couche 183 de SiGe relaxé par gravure avec arrêt sur l'élément 139, ce qui permet d'obtenir la configuration illustrée à la figure 51. L'élément 139 en Silicium conserve une contrainte en tension dans un plan parallèle à la couche 12.

On procède ensuite au retrait de la couche 173 de SiO₂ et des bandes 140, 141 et 142, comme illustré à la figure 52. On fournit ainsi un accès à l'élément de SiGe 172 d'une part et à l'élément de Si 139 d'autre part.

On procède enfin au retrait des éléments 130, 131 et 132 pour former des gorges par gravure. Les gorges sont alors remplies de matériau isolant pour former des éléments 1320, 1321 et 1322. Cela permet de former des tranchées d'isolation profondes, généralement désignées par le terme **STI** (pour Shallow Trench Isolation en langue anglaise), comme illustré à la figure 53. On forme ainsi une isolation entre une première zone de formation de transistors pMOS et une deuxième zone de formation de transistors nMOS.

Ainsi, à l'issue du procédé des étapes d'un procédé de fabrication selon un quatrième mode de réalisation, on dispose :
- d'un élément 172 en SiGe contraint en compression pour la formation du canal de transistors pMOS dans la première zone ;
- d'un élément 139 en Silicium contraint en tension pour la formation du canal de transistors nMOS dans la deuxième zone.

D'autres zones de la structure peuvent présenter une couche de Silicium non contraint pour la formation d'autres transistors.

Les éléments 139 et 172 sont obtenus à partir d'un même dépôt initial de SiGe par épitaxie, avec un nombre réduit d'étapes de masquage et de photolithographie.

## Revendications

1. Procédé de fabrication d'un circuit intégré (1) comportant un transistor nMOS et un transistor pMOS, comprenant les étapes de :
- fournir un substrat (11) présentant une couche de Silicium (13) disposée sur une couche d'isolant (12) et une couche de masque dur (14) disposée sur la couche de Silicium, des première et deuxième ouvertures (51, 52) ceinturées par le masque dur et donnant accès respectivement à des première et deuxième zones (151, 152) de la couche de Silicium (13) ;
- réaliser un dépôt conforme d'isolant (23) sur les première et deuxième zones (151, 152) et sur le masque dur (14) ;
- réaliser une gravure anisotrope du dépôt conforme d'isolant (23) de façon à découvrir une partie des première et deuxième zones (151, 152) et de façon à conserver un espaceur (231, 232, 233, 234) contre des parois latérales du masque dur (14) ceinturant les première et deuxième ouvertures (51, 52) ;
- former simultanément des premier et deuxième dépôts (31, 32) d'alliage de SiGe par épitaxie respectivement sur les première et deuxième zones de la couche de Silicium pour former un premier empilement de la couche de Silicium et du premier dépôt d'une part, et un deuxième empilement de la couche de Silicium et du deuxième dépôt d'autre part ;
- recouvrir le deuxième dépôt (32) d'une couche de protection (24) et maintenir un accès au premier dépôt (31) ; puis
- enrichir la première zone (151) en Germanium par diffusion depuis le premier dépôt (31) ;
- dépôt d'une couche de protection (251) sur le premier empilement ;
- procéder au retrait de la couche de protection (24) du deuxième dépôt (32) ;
- réaliser une gravure jusqu'à la couche d'isolant (12), pour former des gorges (61, 62) entre le masque dur (14) et deux bords opposés du deuxième empilement, cette étape de gravure comprenant une gravure desdits espaceurs et une gravure de la périphérie de la deuxième zone ; puis
- former une couche de Silicium contrainte en tension (139) dans la deuxième zone par amorphisation de la deuxième zone et de la partie basse du deuxième dépôt et conservation d'une partie haute cristallisée (321) dans le deuxième dépôt ; puis
- procéder au retrait de la couche de protection 251 du premier empilement ;
- cristalliser le deuxième dépôt et la deuxième zone pour contraindre la deuxième zone en tension.

2. Procédé de fabrication selon la revendication 1, dans lequel ledit enrichissement de la première zone en Germanium comprend une étape de condensation du Germanium vers la première zone.

3. Procédé de fabrication selon la revendication 2, dans lequel ledit enrichissement comprend une étape d'oxydation thermique et de recuit du deuxième dépôt.

4. Procédé de fabrication selon l'une quelconque des revendications précédentes, dans lequel la cristallisation du deuxième dépôt et de la deuxième zone pour contraindre la deuxième zone en tension est suivie d'une étape de retrait du deuxième dépôt.

5. Procédé de fabrication selon l'une quelconque des revendications précédentes, dans lequel ladite étape de gravure forme une gorge entre une partie du masque dur séparant les première et deuxième ouvertures et un bord du deuxième empilement.

6. Procédé de fabrication selon l'une quelconque des revendications précédentes, dans lequel lesdits premier et deuxième dépôts sont formés sur une hauteur inférieure à celle du masque dur, le procédé comprenant des étapes d'implantation inclinée de Carbone ou d'Oxygène dans ledit deuxième dépôt selon au moins deux directions d'implantation différentes, de façon à former une zone médiane du deuxième dépôt dans laquelle la concentration d'ions implantés est supérieure à celle de la périphérie de ce deuxième dépôt, ladite étape de gravure jusqu'à la couche d'isolant comprenant une gravure de la périphérie de l'empilement de la deuxième zone et du deuxième dépôt.

7. Procédé de fabrication selon l'une quelconque des revendications précédentes, comprenant une étape de formation d'une tranchée d'isolation profonde entre les première et deuxième ouvertures postérieurement aux étapes de cristallisation du deuxième dépôt et de la deuxième zone pour contraindre la deuxième zone en tension.

8. Procédé de fabrication selon l'une quelconque des revendications précédentes, comprenant une étape de formation d'un transistor nMOS dont le canal inclut ladite deuxième zone contrainte en tension, et comprenant une étape de formation d'un transistor pMOS dont le canal inclut ladite première zone enrichie en Germanium.

9. Procédé de fabrication selon l'une quelconque des revendications précédentes, dans lequel lesdits premier et deuxième dépôts présentent une concentration en Germanium comprise entre 15 et 35 %.

## Patentansprüche

1. Herstellungsverfahren zum Herstellen einer integrierten Schaltung (1), die einen nMOS-Transistor und einen pMOS-Transistor beinhaltet, umfassend die folgenden Schritte:
- Bereitstellen eines Substrats (11), aufweisend eine Siliziumschicht (13), die auf einer Isolierstoffschicht (12) angeordnet ist, und eine Hartmaskenschicht (14), die auf der Siliziumschicht angeordnet ist, erste und zweite Öffnungen (51, 52), die von der Hartmaske umfasst werden und jeweils Zugang zu ersten beziehungsweise zweiten Zonen (151, 152) der Siliziumschicht (13) ermöglichen;
- Ausführen einer konformen Isolierstoffabscheidung (23) auf den ersten und zweiten Zonen (151, 152) und auf der Hartmaske (14);
- Ausführen eines anisotropen Ätzens der konformen Isolierstoffabscheidung (23), so dass ein Teil der ersten und zweiten Zonen (151, 152) freigelegt wird und ein Abstandhalter (231, 232, 233, 234) an seitlichen Wänden der Hartmaske (14) beibehalten wird, welche die ersten und zweiten Öffnungen (51, 52) umfasst;
- gleichzeitiges Bilden von ersten und zweiten Abscheidung (31, 32) einer SiGe-Legierung durch Epitaxie auf den ersten bzw. zweiten Zonen der Siliziumschicht, um einen ersten Stapel aus der Siliziumschicht und der ersten Abscheidung zum einen und einen zweiten Stapel aus der Siliziumschicht und der zweiten Abscheidung zum anderen zu bilden;
- Überziehen der zweiten Ablagerung (32) mit einer Schutzschicht (24) und Aufrechterhalten des Zugangs zu der ersten Abscheidung (31); dann
- Anreichern der ersten Zone (151) mit Germanium durch Diffusion von der ersten Abscheidung (31) aus;
- Abscheiden einer Schutzschicht (251) auf dem ersten Stapel;
- Entfernen der Schutzschicht (24) von der zweiten Abscheidung (32);
- Ausführen eines Ätzens bis zu der Isolierstoffschicht (12), um Rillen (61, 62) zwischen der Hartmaske (14) und zwei entgegengesetzten Rändern des zweiten Stapels zu bilden, wobei dieser Ätzschritt ein Ätzen der Abstandhalter und ein Ätzen des Umfangs der zweiten Zone umfasst; dann
- Bildung einer verspannten Siliziumschicht (139) in der zweiten Zone durch Amorphisierung der zweiten Zone und des unteren Teils der zweiten Abscheidung und Beibehalten eines kristallisierten oberen Teils (321) in der zweiten Abscheidung; dann
- Entfernen der Schutzschicht 251 von dem ersten Stapel;
- Kristallisieren der zweiten Abscheidung und der zweiten Zone, um die zweite Zone zu verspannen.

2. Herstellungsverfahren nach Anspruch 1, wobei das Anreichern der ersten Zone mit Germanium einen Schritt des Kondensierens des Germaniums zu der ersten Zone hin umfasst.

3. Herstellungsverfahren nach Anspruch 2, wobei das Anreichern einen Schritt des thermischen Oxidierens und des Temperns der zweiten Abscheidung umfasst.

4. Herstellungsverfahren nach einem der vorhergehenden Ansprüche, wobei auf das Kristallisieren der zweiten Abscheidung und der zweiten Zone, um die zweite Zone zu verspannen, ein Schritt des Entfernens der zweiten Abscheidung folgt.

5. Herstellungsverfahren nach einem der vorhergehenden Ansprüche, wobei der Schritt des Ätzens eine Rille zwischen einem Teil der Hartmaske, der die ersten und zweiten Öffnungen trennt, und einem Rand des zweiten Stapels bildet.

6. Herstellungsverfahren nach einem der vorhergehenden Ansprüche, wobei die ersten und zweiten Abscheidungen über eine Höhe gebildet werden, die geringer als die der Hartmaske ist, wobei das Verfahren Schritte der schrägen Implantation von Kohlenstoff oder von Sauerstoff in die zweite Abscheidung gemäß mindestens zwei verschiedenen Implantationsrichtungen umfasst, so dass eine mittlere Zone der zweiten Abscheidung gebildet wird, in der die Konzentration von implantierten Ionen höher ist als die des Umfangs dieser zweiten Abscheidung, wobei der Schritt des Ätzens bis zu der Isolierstoffschicht ein Ätzen des Umfangs des Stapels aus der zweiten Zone und der zweiten Abscheidung umfasst.

7. Herstellungsverfahren nach einem der vorhergehenden Ansprüche, umfassend einen Schritt des Bildens eines tiefen Isolationsgrabens zwischen den ersten und zweiten Öffnungen nach den Schritten des Kristallisierens der zweiten Abscheidung und der zweiten Zone, um die zweite Zone zu verspannen.

8. Herstellungsverfahren nach einem der vorhergehenden Ansprüche, umfassend einen Schritt des Bildens eines nMOS-Transistors, dessen Kanal die verspannte zweite Zone beinhaltet, und umfassend einen Schritt des Bildens eines pMOS-Transistors, dessen Kanal die an Germanium angereicherte erste Zone beinhaltet.

9. Herstellungsverfahren nach einem der vorhergehenden Ansprüche, wobei die ersten und zweiten Abscheidungen eine Germaniumkonzentration zwischen 15 und 35 % aufweisen.

## Claims

1. Process for fabricating an integrated circuit (1) comprising an nMOS transistor and a pMOS transistor, comprising the steps of:
- providing a substrate (11) comprising a silicon layer (13) placed on a layer of insulator (12), a layer of hard mask (14) placed on the silicon layer, and first and second apertures (51, 52) encircled by the hard mask and giving access to first and second regions (151, 152) of the silicon layer (13), respectively;
- carrying out conformal deposition of insulator (23) on the first and second regions (151, 152) and on the hard mask (14);
- anisotropically etching the conformal deposit of insulator (23) so as to uncover one portion of the first and second regions (151, 152) and so as to preserve a spacer (231, 232, 233, 234) against sidewalls of the hard mask (14) encircling the first and second apertures (51, 52);
- simultaneously forming first and second deposits (31, 32) of SiGe alloy by epitaxy on the first and second regions of the silicon layer in order to form a first stack of the silicon layer and of the first deposit on the one hand, and a second stack of the silicon layer and of the second deposit on the other hand, respectively;
- covering the second deposit (32) with a protective layer (24) and maintaining an access to the first deposit (31); then
- enriching the first region (151) in germanium by diffusion from the first deposit (31);
- depositing a protective layer (251) on the first stack;
- removing the protective layer (24) from the second deposit (32);
- carrying out an etch up to the layer of insulator (12), in order to form trenches (61, 62) between the hard mask (14) and two opposite edges of the second stack, this etching step comprising an etch of said spacers and an etch of the periphery of the second region; then
- forming a tensilely strained silicon layer (139) in the second region via an amorphization of the second region and of the bottom portion of the second deposit and preservation of a crystallized top portion (321) in the second deposit; then
- removing the protective layer 251 from the first stack;
- crystallizing the second deposit and the second region in order to tensilely strain the second region.

2. Fabricating process according to Claim 1, wherein said enrichment of the first region in germanium comprises a step of condensing germanium into the first region.

3. Fabricating process according to Claim 2, wherein said enrichment comprises a step of thermally oxidizing and annealing the second deposit.

4. Fabricating process according to any one of the preceding claims, wherein the crystallization of the second deposit and of the second region in order to tensilely strain the second region is followed by a step of removing the second deposit.

5. Fabricating process according to any one of the preceding claims, wherein said etching step forms a trench between a portion of the hard mask separating the first and second apertures and an edge of the second stack.

6. Fabricating process according to any one of the preceding claims, wherein said first and second deposits are formed so as to have a height smaller than that of the hard mask, the process comprising steps of inclined implantation of carbon or of oxygen into said second deposit in at least two different implantation directions, so as to form a median region of the second deposit, in which region the concentration of implanted ions is higher than the concentration of implanted ions on the periphery of this second deposit, said step of etching up to the layer of insulator comprising an etch of the periphery of the stack of the second region and of the second deposit.

7. Fabricating process according to any one of the preceding claims, comprising a step of forming a deep trench isolation between the first and second apertures subsequently to the steps of crystallizing the second deposit and the second region in order to tensilely strain the second region.

8. Fabricating process according to any one of the preceding claims, comprising a step of forming an nMOS transistor the channel of which includes said second tensilely strained region, and comprising a step of forming a pMOS transistor the channel of which includes said first region enriched in germanium.

9. Fabricating process according to any one of the preceding claims, wherein said first and second deposits have a germanium concentration comprised between 15 and 35%.
